# EUROPÄISCHE PATENTANMELDUNG

(11) **EP 0 736 777 A2**
(43) Veröffentlichungstag der Anmeldung: **09.10.1996**
(21) Anmeldenummer: 96250076.5
(22) Anmeldetag: 02.04.1996
(51) Int. Cl.: G01R 31/327

(54) **Leistungsschalter mit einer Messeinrichtung**

(30) Priorität: 03.04.1995 DE 19513336
(71) Anmelder: SIEMENS AKTIENGESELLSCHAFT, 80333 München (DE)
(72) Erfinder: Lorenz, Dieter, 12207 Berlin (DE); Meinherz, Manfred, 13467 Berlin (DE)

(57) **Zusammenfassung**

Ein Hochspannungs-Leistungsschalter (1) ist mit einer Meßeinheit (12, 18) zur Messung eines Stromes oder einer Spannung versehen. Die Meßeinheit (12) weist einen Oberflächenwellensensor (22) sowie eine Übertragungseinrichtung (33) zur drahtlosen Meßwertübertragung auf. Wahlweise können Umsetzer (15) zur drahtgebundenen Weiterleitung der Meßwerte oder Umsetzer (16) zur drahtlosen Weiterleitung vorgesehen sein.

## Beschreibung

Die Erfindung betrifft einen Leistungsschalter mit wenigstens einer Unterbrechereinheit und einem die Unterbrechereinheit unterstützenden Tragwerk sowie mit einer Meßeinheit zur Strom- und/oder Spannungsmessung.

Meßeinheiten der genannten Art werden in der Energietechnik wahlweise vorgesehen, um Geräte der Schutztechnik zu betreiben oder um Energiemessungen durchzuführen. Im Prinzip ist es sowohl möglich, Meßeinheiten in einer Schaltanlage getrennt von den anderen Komponenten anzuordnen oder sie baulich ganz oder teilweise mit anderen Anlagenteilen zu vereinigen. Handelt es sich um eine Mittel- oder Hochspannungsschaltanlage, so kommt zumindest bei einer Verwendung von induktiven Strom- und Spannungswandlern mit Rücksicht auf deren beträchtlichen Raumbedarf nur eine gesonderte Aufstellung in Betracht (vgl. DE-Buch "BBC-Handbuch für Schaltanlagen", 3. Aufl., 1965, Seiten 597 bis 611). Es stehen jedoch auch Meßeinheiten mit geringerem Raumbedarf zur Verfügung, die nach einem optoelektronischen Prinzip arbeiten. Jedoch stellen derartige Meßeinrichtungen im Vergleich zu konventionellen induktiven Meßeinrichtungen erhöhte Anforderungen an die Auswertung und Übertragung der abgegebenen Signale und eignen sich daher mit Rücksicht auf den damit verbundenen erhöhten Aufwand nicht für den allgemeinen Einsatz.

Der Erfindung liegt die Aufgabe zugrunde, eine für Hochspannungs-Schaltanlagen geeignete Meßeinrichtung zu schaffen, die eine im Vergleich zu anderen bekannten Meßeinrichtungen sehr geringe Baugröße aufweist, nur geringe Anforderungen an eine Versorgung mit Hilfsenergie stellt sowie den Anforderungen an eine rauhe Betriebsumgebung gewachsen ist, wie sie bei Freiluft-Schaltanlagen besteht.

Gemäß der Erfindung wird diese Aufgabe dadurch gelöst, daß
- bei einer Ausbildung als Mittel- oder Hochspannungs-Leistungsschalter die Meßeinheit wenigstens einen Oberflächenwellensensor aufweist und an einer spannungführenden äußeren Armatur des Leistungsschalters angebracht ist,
- dem Oberflächenwellensensor wenigstens eine übertragungseinrichtung zur drahtlosen Meßwertübertragung zugeordnet ist.

Die Vorteile dieser Meßeinheit beruhen insofern auf den Eigenschaften der Oberflächenwellensensoren, als diese Bauelemente Festkörper darstellen und nach dem Differentialverfahren arbeiten (vgl. DE-Buch "Sensortechnik", Hüthig-Verlag, Heidelberg, 1989, Seiten 270 bis 271). Dadurch ergibt sich eine hohe Sicherheit gegen Fremdeinflüsse, wie sie in Freiluftschaltanlagen auftreten. Da die zum Betrieb des Oberflächenwellensensors erforderliche Hilfsenergie gering ist, kann diese am Einbauort der Meßeinheit auf einfache Weise bereitgestellt werden. Die drahtlose Übertragung von Meßsignalen stellt andererseits keine nennenswerte Erschwernis dar, weil hierfür geeignete Verfahren und Einrichtungen in vielen Ausführungsformen allgemein zu Verfügung stehen.

Die im Rahmen der Erfindung zur Anwendung gelangenden Oberflächenwellensensoren sind im Prinzip sowohl zur Strommessung als auch zur Spannungsmessung geeignet. Es empfiehlt sich daher, gesonderte Meßeinrichtungen zur Strommessung und zur Spannungsmessung mit wenigstens je einem Oberflächenwellensensor vorzusehen.

An dem auf Erdpotential befindlichen Tragwerk kann eine Empfangseinrichtung für von der Übertragungseinrichtung abgegebene Signale angeordnet sein. Von dort können die Meßwerte zusammen weiteren Parametern, wie sie im Betrieb des Leistungsschalters anfallen, auf dem üblichen Weg zu einer Schaltwarte übertragen werden. Eine weitere geeignete Möglichkeit besteht darin, daß an dem Tragwerk eines mehrpoligen Leistungsschalters ein gemeinsamer Umsetzer zur Umwandlung der Ausgangsgrößen der den einzelnen Polen zugeordneten Empfangseinrichtungen in eine drahtlos zu einer entfernt angeordneten Auswerteeinrichtung übertragbare Signalfolge angeordnet ist.

Oberflächenwellensensoren sind in der Lage, äußerst geringe mechanische Deformationen in elektronisch auswertbare Größen umzusetzen. Dies kann für die Zwecke der Erfindung z. B. dadurch geschehen, daß die Meßeinheit zur Strommessung einen Meßmodul mit wenigstens zwei magnetisierbaren Polstücken aufweist, die in einem Magnetfeld angeordnet sind, das von dem den Leistungsschalter durchfließenden Strom erregt ist und daß der wenigstens eine Oberflächenwellensensor durch zwischen den magnetisierbaren Polstücken wirkende Kräfte beaufschlagbar ist. Eine solche Meßeinheit ist im Prinzip in der Lage, Ströme im gesamten vorkommenden Bereich, d. h. sowohl normale Betriebs ströme als auch Überströme bis zu Kurzschlußströmen in meßtechnisch verwertbare Signale umzusetzen. Jedoch kann sowohl durch mechanische als auch durch elektrische bzw. elektronische Mittel für einen gewünschten Verlauf der Kennlinie der Übertragung gesorgt sein.

Beim Einsatz eines Oberflächenwellensensors zur Spannungsmessung kann die Meßeinheit wenigstens zwei dielektrische Polstücke aufweisen, die in einem elektrischen Feld angeordnet sind, das mit der an dem Leistungsschalter anliegenden Spannung verknüpft ist und daß der wenigstens eine Oberflächenwellensensor durch zwischen den dielektrischen Polstücken wirkende Kräfte beaufschlagbar ist. Damit ist ein prinzipiell gleicher oder ähnlicher mechanischer Grundbaustein für beide Meßaufgaben einsetzbar.

Wie schon erwähnt, ist die zum Betrieb eines Oberflächenwellensensors benötigte Hilfsenergie gering. Im Rahmen der Erfindung kann der Meßmodul z. B. eine Hilfswandlereinheit zur Bereitstellung einer Hilfsenergie zum Betrieb des wenigstens einen Oberflächenwellensensors aufweisen, wobei die Hilfswandlereinheit mit einem im Betrieb des Leistungsschalters auftretenden Magnetfeld und/oder einem elektrischen Feld zusammenwirkt.

Zum wirtschaftlichen Aufbau von Hochspannungs-Schaltanlagen kann dadurch beigetragen werden, daß die Hilfswandlereinheit zusammen mit dem Meßmodul und der Übertragungseinrichtung durch einen gemeinsamen Träger zu der Meßeinheit baulich vereinigt ist, die Befestigungsorgane zur Anbringung an einer Anschlußvorrichtung des Leistungsschalters aufweist.

Besonders vorteilhaft ist die Verwendung von passiven Oberflächenwellensensoren, wie sie in der DE-Zeitschrift "Siemens-Zeitschrift Special", FuE, Frühjahr 1994, Seiten 2 bis 6, beschrieben sind. Im Rahmen der Erfindung kann daher die Meßeinheit einen passiven Oberflächenwellensensor enthalten, dem durch eine kombinierte Sende- und Empfangseinheit eine Hilfsenergie zuführbar ist und der unter Verwertung der Hilfsenergie eine Messung durchführt und das Meßergebnis gleichfalls als Funksignal an die kombinierte Sende- und Empfangseinheit abgibt. In diesem Zusammenhang wird keine gesonderte, auf Hochspannungspotential befindliche Hilfswandlereinheit benötigt. Die erwähnten Anordnungen mit magnetisierbaren oder mit dielektrischen Polstücken sind vorteilhaft auch in Verbindung mit passiven Oberflächenwellensensoren anwendbar.

Die Erfindung wird im folgenden anhand der in den Figuren dargestellten Ausführungsbeispiele näher erläutert.

Die Figur 1 zeigt einen dreipoligen Hochspannungs-Leistungsschalter mit Meßeinrichtungen auf der Basis von Oberflächenwellensensoren.

In der Figur 2 sind in der Draufsicht schematisch zwei Hochspannungs-Leistungsschalter gezeigt, die jeweils einen Umsetzer zur Übertragung von Meßwerten zu einer entfernt angeordneten Auswerteeinrichtung besitzen.

In der Figur 3 ist schematisch eine Meßeinrichtung zur Strommessung mit einem Oberflächenwellensensor gezeigt.

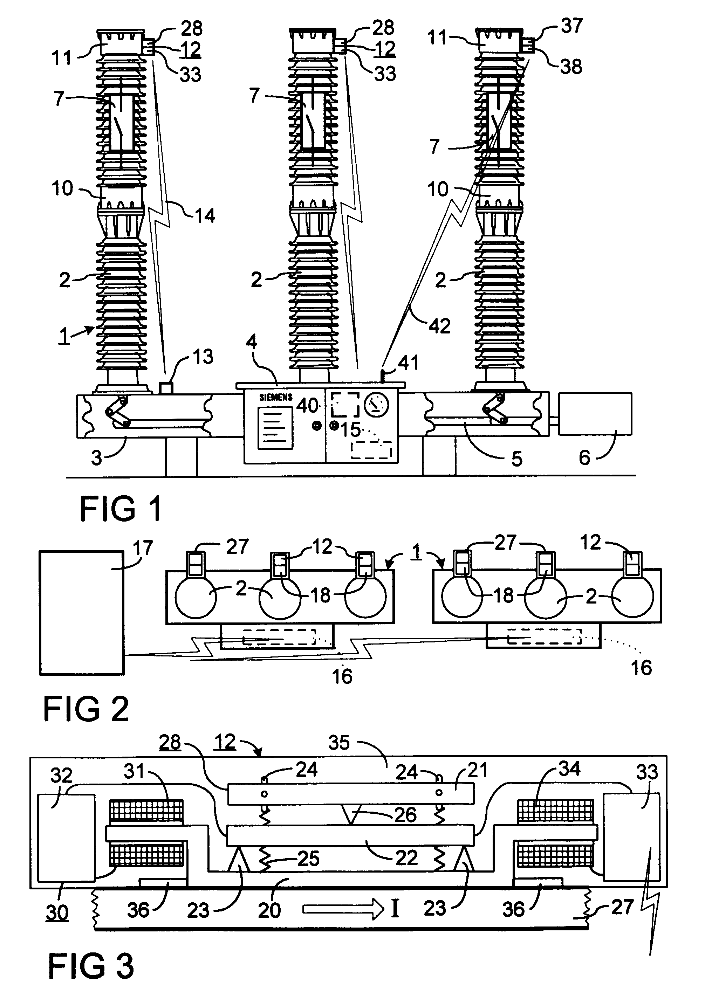

Der in der Figur 1 vereinfacht gezeigte Hochspannungs-Leistungsschalter 1 ist dreipolig ausgebildet und weist drei Polsäulen 2 auf, die jeweils eine oder mehrere Unterbrechereinheiten 7 enthalten können. Die Polsäulen 2 sind auf einem gemeinsamen Tragwerk 3 befestigt, das in bekannter Weise als Rahmengestell ausgebildet sein kann. Ein frontseitig dem Tragwerk 3 zugeordneter Steuerschrank 4 enthält die zum Betrieb des Leistungsschalters 1 benötigten Hilfseinrichtungen wie Verdichter, Getriebemotoren, Schütze, Relais, Befehls- und Meldegeräte in der jeweils benötigten Kombination und Anzahl. An dem Tragwerk 3 ist ferner ein schematisch gezeigtes Koppelgestänge 5 gelagert, das die in den Polsäulen erhaltenen Unterbrechereinheiten 7 einer gemeinsamen Antriebsvorrichtung 6 verbindet.

Jede der Polsäulen 2 weist eine untere Anschlußarmatur 10 sowie eine obere Anschlußarmatur 11 auf. An jeder der oberen Anschlußarmaturen 11 ist eine Meßeinheit 12 angebracht, die außer einem Meßmodul 28 eine Übertragungseinrichtung 33 enthält. Zu jeder Meßeinheit 12 gehört eine an dem Tragwerk 3 angebrachte Empfangseinrichtung 13, die mit der Meßeinheit 12 drahtlos in Verbindung steht, wie durch einen den Übertragungsweg symbolisierenden Zick-zack-Pfeil 14 angedeutet ist. In dem Steuerschrank 4 ist ein Umsetzer 15 untergebracht, der die von dem Empfangseinrichtungen 13 aufgenommenen Informationen zur weiteren Auswertung aufbereitet, z. B. in der Weise, daß die Meßwerte drahtgebunden zusammen mit weiteren im Betrieb des Leistungsschalters 1 anfallenden Signalen zur einer entfernten Schaltwarte übertragen werden.

Abweichend von der Darstellung in den Figuren können auch an der unteren Anschlußarmatur oder an beiden Anschlußarmaturen Meßeinheiten angebracht sein. Ferner kann eine gemeinsame Empfangseinrichtung für die Meßeinheiten eines mehrpoligen Leistungsschalters vorgesehen sein. Eine solche gemeinsame Empfangseinrichtung kann geschützt in dem Steuerschrank 4 untergebracht werden, wobei an der Außenseite nur eine Antenne angebracht ist.

Als weitere Möglichkeit der Übertragung von Meßwerten ist in der Figur 2 angedeutet, daß jeder von mehreren Leistungsschaltern 1 einer Schaltanlage einen gemeinsamen Umsetzer 16 für die den Polsäulen zugeordneten Meßeinheiten 12 besitzen, wobei in diesem Fall eine drahtlose Übertragung zu einer entfernt angeordneten Auswerteeinrichtung 17 vorgesehen ist. Die Übertragungseinrichtung 16 kann in diesem Fall so ausgebildet sein, daß sie neben den zu erfassenden Meßwerten auch weitere Parameter aus dem Betrieb des Leistungsschalters 1 zu übertragen vermag.

Den prinzipiellen Aufbau einer Meßeinheit 12 zeigt schematisch die Figur 3. Das Kernstück der Meßeinheit 12 ist ein Meßmodul 28, der ein feststehendes magnetisierbares Polstück 20 sowie ein parallel hierzu angeordnetes bewegbares Polstück 21 aufweist. Zwischen den Polstücken 20 und 21 befindet sich ein Oberflächenwellensensor 22, der etwa balkenartig ausgebildet ist und nahe seinen Enden auf schneidenartigen Widerlagern 23 ruht. Das bewegbare Polstück 21 ist in Langlochführungen 24 verschiebbar und mittels Schraubenfedern 25 in Richtung des feststehenden Polstückes 20 vorgespannt. Mittels einer an dem bewegbaren Polstück 21 etwa mittig angebrachten Schneide 26 wird auf diese Weise auf den Oberflächenwellensensor 22 eine Biegespannung aufgebracht.

Der erläuterten mechanischen Vorspannung des Oberflächenwellensensors 22 überlagert sich eine magnetische Kraft aufgrund eines Stromes, der durch eine parallel zu dem feststehenden Polstück 20 angeordnete Anschlußschiene 27 fließt. Wie näher der Figur 2 zu entnehmen ist, ist jede der Polsäulen 2 mit Anschlußschienen versehen, von denen in der Draufsicht jeweils die zu der oberen Anschlußarmatur gehörende Anschlußschiene 27 sichtbar ist. Die zum Betrieb des Oberflächenwellensensors 22 benötigte Hilfsenergie wird durch eine Hilfswandlereinheit 30 geliefert, die aus einer auf einem Endschenkel des feststehenden Polstückes 20 angeordneten Spule 31 und einem elektronischen Spannungswandler 32 besteht. Ein von dem Oberflächenwellensensor 22 abnehmbares Meßsignal wird einer Übertragungseinrichtung 33 zugeführt, die ihrerseits aus einer weiteren Spule 34 gespeist wird, die gleichfalls auf einem Endschenkel des feststehenden Polstückes 20 sitzt. Es kann jedoch auch eine gemeinsame Hilfswandlereinheit für den Oberflächenwellensensor 22 und für die Übertragunsgeinrichtung 33 vorgesehen sein.

Wie die Figur 3 noch zeigt, weist die Meßeinheit 12 einen gemeinsamen Träger 35 auf, der mit Befestigungsvorrichtungen 36 versehen ist. Diese gestatten die direkte Befestigung der Meßeinheit 12 an der Anschlußvorrichtung 10 bzw. 11 oder beiden damit in Verbindung stehenden Anschlußschienen 27.

Der anhand der Figur 3 erläuterte Aufbau eines Meßmoduls 28 ist prinzipiell auch zur Messung von Spannungen geeignet.

Hierzu sind anstelle der magnetisierbaren Polstücke 20 und 21 dielektrische Polstücke geeignet. Entsprechend ausgebildete Meßeinheiten 18 für die Spannungsmessung sind in der Figur 2 gleichfalls gezeigt. Es kann zweckmäßig sein, die Meßeinheiten 18 mit kapazitiv wirkenden Hilfswandlereinheiten auszurüsten. Ferner können einheitliche kapazitive Hilfswandlereinheiten zur Bereitstellung der Hilfsenergie für beide Arten von Meßeinheiten (12 bzw. 18) vorgesehen sein.

Während vorstehend eine Meßeinheit beschrieben wurde, die eine dem Oberflächenwellensensor zugeordnete Hilfswandlereinheit aufweist, können auch passive Oberflächenwellensensoren verwendet werden, denen eine Hilfsenergie durch ein Funksignal zuführbar ist. Eine solche Meßeinheit 37 zur Strommessung ist zusammen mit einer weiteren Meßeinheit 38 zur Spannungsmessung an der rechten Polsäule 2 in Figur gezeigt. Diesen Meßeinheiten zugeordnet ist eine kombinierte Sende- und Empfangseinheit 40, die sich in dem Steuerschrank 4 befindet. Eine am Steuerschrank angeordnete Antenne 41 stellt die Verbindung zu den Meßeinheiten 37 und 38 her, wie durch einen Zick-Zack-Pfeil 42 dargestellt ist.

## Patentansprüche

1. Leistungsschalter mit wenigstens einer Unterbrechereinheit (7) und einem die Unterbrechereinheit (1) unterstützenden Tragwerk (3) sowie mit einer Meßeinheit (12, 18) zur Strom- und/oder Spannungsmessung,
**dadurch gekennzeichnet**, daß
- bei einer Ausbildung als Mittel- oder Hochspannungs-Leistungsschalter (1) die Meßeinheit (12, 18) wenigstens einen Oberflächenwellensensor (22) aufweist und an einer spannungführenden äußeren Armatur (10, 11) des Leistungsschalters (1) angebracht ist,
- dem Oberflächenwellensensor (22) wenigstens eine Übertragungseinrichtung (33) zur drahtlosen Meßwertübertragung zugeordnet ist.

2. Leistungsschalter nach Anspruch 1,
**dadurch gekennzeichnet**, daß gesonderte Meßeinheiten (12, 18) zur Strommessung und zur Spannungsmessung mit wenigstens je einem Oberflächenwellensensor (22) vorgesehen sind.

3. Leistungsschalter nach Anspruch 1 oder 2,
**dadurch gekennzeichnet**, daß an dem auf Erdpotential befindlichen Tragwerk (3) eine Empfangseinrichtung (13) für von der Übertragungseinrichtung (33) abgegebene Signale angeordnet ist.

4. Leistungsschalter nach Anspruch 3,
**dadurch gekennzeichnet**, daß an dem Tragwerk (3) eines mehrpoligen Leistungsschalters (1) ein gemeinsamer Umsetzer (16) zur Umwandlung der Ausgangsgrößen der den einzelnen Polen zugeordneten Empfangseinrichtungen (13) in eine drahtlos zu einer entfernt angeordneten Auswerteeinrichtung (17) übertragbare Signalfolge angeordnet ist.

5. Leistungsschalter nach einem der vorangehenden Ansprüche,
**dadurch gekennzeichnet**, daß die Meßeinheit (12) zur Strommessung ein Meßmodul (28) mit wenigstens zwei magnetisierbaren Polstücken (20, 21) aufweist, die in einem Magnetfeld angeordnet sind, das von dem den Leistungsschalter (1) durchfließenden Strom erregt ist und daß der wenigstens eine Oberflächenwellensensor (22) durch zwischen den magnetisierbaren Polstücken (20, 21) wirkende Kräfte beaufschlagbar ist.

6. Leistungsschalter nach einem der vorangehenden Ansprüche,
**dadurch gekennzeichnet**, daß die Meßeinheit (18) zur Spannungsmessung wenigstens zwei dielektrische Polstücke aufweist, die in einem elektrischen Feld angeordnet sind, das mit der an dem Leistungsschalter (1) anliegenden Spannung verknüpft ist und daß der wenigstens eine Oberflächenwellensensor durch zwischen den dielektrischen Polstücken wirkende Kräfte beaufschlagbar ist.

7. Leistungsschalter nach einem der vorangehenden Ansprüche,
**dadurch gekennzeichnet**, daß der Meßmodul (28) eine Hilfswandlereinheit (30) zur Bereitstellung einer Hilfsenergie zum Betrieb des wenigstens einen Oberflächenwellensensors (22) aufweist und daß die Hilfswandlereinheit (30) mit einem im Betrieb des Leistungsschalters (1) auftretenden Magnetfeld und/oder einem elektrischen Feld zusammenwirkt.

8. Leistungsschalter nach Anspruch 6,
**dadurch gekennzeichnet**, daß die Hilfswandlereinheit (30) zusammen mit dem Meßmodul (28) und der Übertragungseinheit (33) durch einen gemeinsamen Träger (35) zu der Meßeinheit (12) baulich vereinigt ist, die Befestigungsorgane (36) zur Anbringung an einer Anschlußvorrichtung (27) des Leistungsschalters (1) aufweist.

9. Leistungsschalter nach einem der Ansprüche 1, 5 und 6,
**dadurch gekennzeichnet**, daß die Meßeinheit (37, 38) einen passiven Oberflächenwellensensor enthält, dem durch eine kombinierte Sende- und Empfangseinheit (40) eine Hilfsenergie zuführbar ist und der unter Verwertung der Hilfsenergie eine Messung durchführt und das Meßergebnis gleichfalls als Funksignal an die kombinierte Sende- und Empfangseinheit (40) abgibt.
